# EUROPEAN PATENT APPLICATION

(11) **EP 4 202 658 A1**
(43) Date of publication of application: **28.06.2023**
(21) Application number: 22208778.5
(22) Date of filing: 22.11.2022
(51) Int. Cl.: G06F 9/30, G06F 13/16

(54) **ZERO CYCLE MEMORY INITIALIZATION**

(30) Priority: 23.12.2021 US 202117560665
(71) Applicant: Intel Corporation, Santa Clara, CA 95054 (US)
(72) Inventor: Ould-Ahmed-Vall, ElMoustapha, Chandler, AZ 85226 (US)
(74) Representative: Samson & Partner Patentanwälte mbB

(57) **Abstract**

Techniques for initializing memory to zeros or random data are described. In some examples, a memory controller initiates a portion of memory to be zeros or random data in response to an execution of an instruction. In some examples, the instruction's opcode indicates the type of data to write. In some examples, an operand of the instruction indicates the type of data to write.

## Description

### BACKGROUND

Computers including phones, servers, and personal computers all utilize memory to store data. This memory includes random access memory, cache memory, non-volatile memory, etc., stores data to be utilized during program execution.

### BRIEF DESCRIPTION OF DRAWINGS

Various examples in accordance with the present disclosure will be described with reference to the drawings, in which:
**FIGS. 1(A)****-(E)** illustrate examples of aspects that may be used in the initialization of at least a proper subset of memory in a particular manner.
**FIG. 2** illustrates examples of hardware to process an instruction such as a memory initialization (MEMINIT) instruction.
**FIG. 3** illustrates examples of a method for memory initialization.
**FIG. 4** illustrates examples of a method to process a memory initialization instruction.
**FIG. 5** illustrates examples of an exemplary system.
**FIG. 6** illustrates a block diagram of examples of a processor that may have more than one core, may have an integrated memory controller, and may have integrated graphics.
**FIG. 7(A)** is a block diagram illustrating both an exemplary in-order pipeline and an exemplary register renaming, out-of-order issue/execution pipeline according to examples.
**FIG. 7(B)** is a block diagram illustrating both an example of an in-order architecture core and an exemplary register renaming, out-of-order issue/execution architecture core to be included in a processor according to examples.
**FIG. 8** illustrates examples of execution unit(s) circuitry, such as execution unit(s) circuitry of FIG. 7(B).
**FIG. 9** is a block diagram of a register architecture according to some examples.
**FIG. 10** illustrates examples of an instruction format.
**FIG. 11** illustrates examples of an addressing field.
**FIG. 12** illustrates examples of a first prefix.
**FIGS. 13(A)****-(D)** illustrate examples of how the R, X, and B fields of the first prefix 1001(A) are used.
**FIGS. 14(A)****-(B)** illustrate examples of a second prefix.
**FIG. 15** illustrates examples of a third prefix.
**FIG. 16** illustrates a block diagram contrasting the use of a software instruction converter to convert binary instructions in a source instruction set to binary instructions in a target instruction set according to examples.

### DETAILED DESCRIPTION

The present disclosure relates to methods, apparatus, systems, and non-transitory computer-readable storage media for initializing at least a proper subset of memory. According to some examples, an instruction, which when executed, causes execution circuitry to initialize at least a proper subset of memory. In some examples, a memory controller or platform controller initializes at least a proper subset of memory without the need for an explicit instruction from a user and/or operating system.

There are times that a programmer would like for a particular subset of memory (e.g., registers, a portion of random access memory (RAM), etc.) to be initialized to a particular value or type of value. For example, in training a machine learning algorithm, there are times when a random value may be used. Instead of having to generate random value with an instruction, and then use the generated random value in a different instruction, it would be beneficial to have a particular subset of memory that is accessible that already has random value available.

Similarly, there are times when it is desirable to have all zeros. The use of zeros may eliminate the possibility that a memory chunk could have acted as a potential source of nondeterministic behavior of a program.

Unfortunately, initializing a chunk of memory For example, to perform a calloc() allocation in C, a current approach is for a compiler to generate a series of zeroing instructions to zero out an array.

Detailed below are examples of systems, apparatuses, etc. that allow for the initialization of at least a proper subset of memory in a particular manner with and/or without intervention. This allows for memory to be primed for a future task or tasks without the need for expending the extra time and energy of individual instructions.

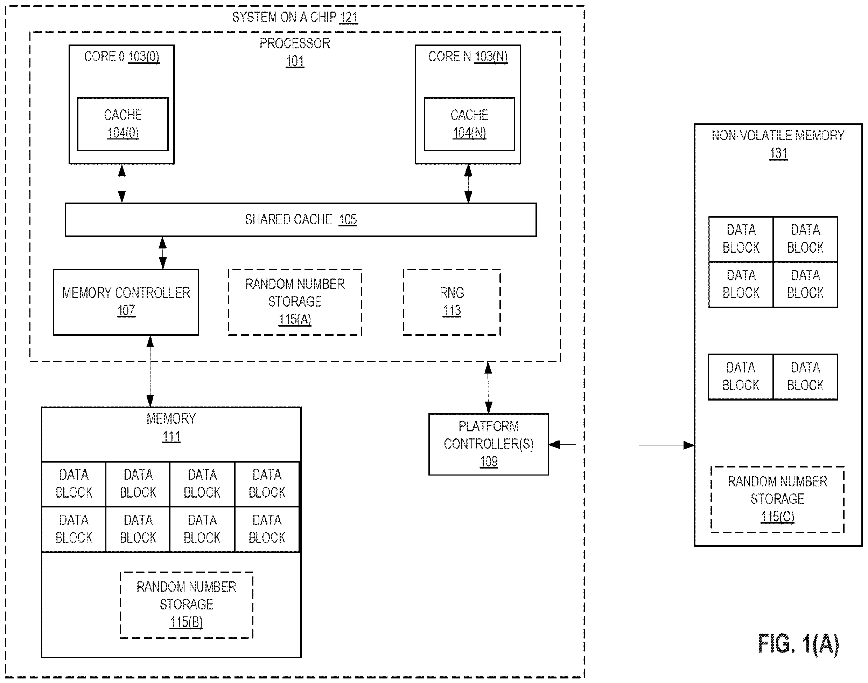

FIGS. 1(A)-(E) illustrate examples of aspects that may be used in the initialization of at least a proper subset of memory in a particular manner. As shown in FIG. 1(A), a plurality of cores 103(0)-INV03(N) include instruction processing resources (an exemplary pipeline is detailed later) which include the use of local caches 104(0)-104(N). In some examples, at least one of the cores is a graphics processing unit (GPU), accelerator processing unit (APU), etc. The cores 103(0)-INV03(N) also utilize a shared cache 105. The shared cache 105 may be a last level cache (LLC) such as L3, L4, etc. cache.

A memory controller 107 is used to access to main memory 111 (e.g., random access memory (RAM)). In particular, the memory controller 107 controls reads and writes to main memory 111. In some examples, the memory controller 107 is integrated within a processor 101. In other examples, the memory controller 107 is external to a processor. In some examples, the memory controller 107 is coupled to, or includes, storage for random numbers (115(A)) to be used when random numbers are to be used as initialization data. A random number generator (RNG) circuitry 113 generates random number to be stored. Note that this circuitry is a part of one or more cores in some examples.

Main memory 111 includes a plurality of data blocks that store data. In some examples, at least some data blocks are dedicated to the storage of random numbers (random number storage 115(B)) to be used when random numbers are to be used as initialization data.

A platform controller 109 is used to access to non-volatile memory 131 (e.g., hard disk, second level memory (2LM), etc.). In particular, the platform controller 109 controls reads and writes to non-volatile memory 131. Non-volatile memory 131 includes a plurality of data blocks that store data. In some examples, at least some data blocks are dedicated to the storage of random numbers (random number storage 115(C)) to be used when random numbers are to be used as initialization data.

In some examples, certain aspects are integrated as part of a processor 101 and/or a system on a chip 121.

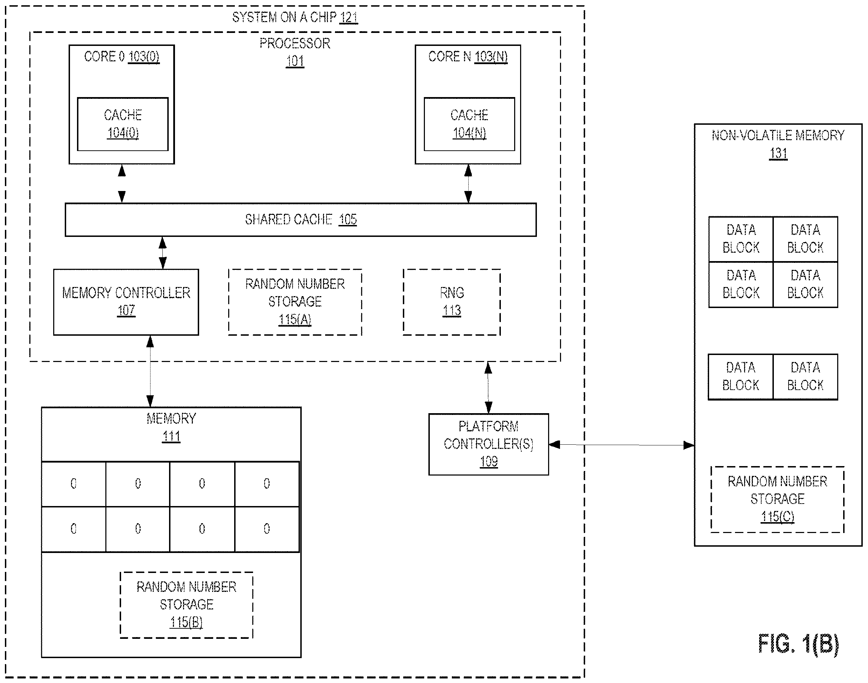

FIG. 1(B) illustrates a portion of the memory 111 being initialized to zero.

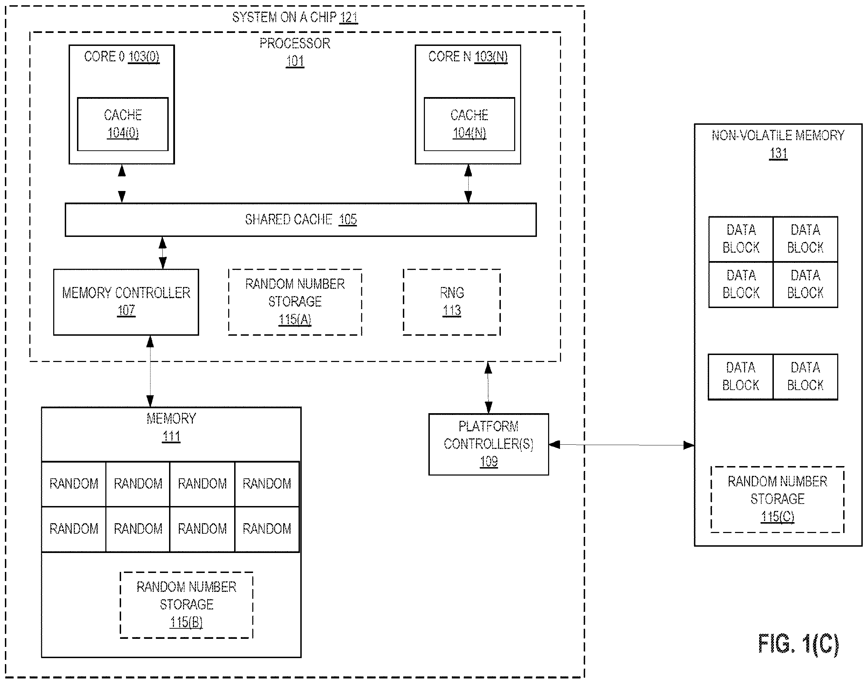

FIG. 1(C) illustrates a portion of the memory 111 being initialized to random values. These random values may come from the random number storage 115(A) or 115(B) depending on the implementation.

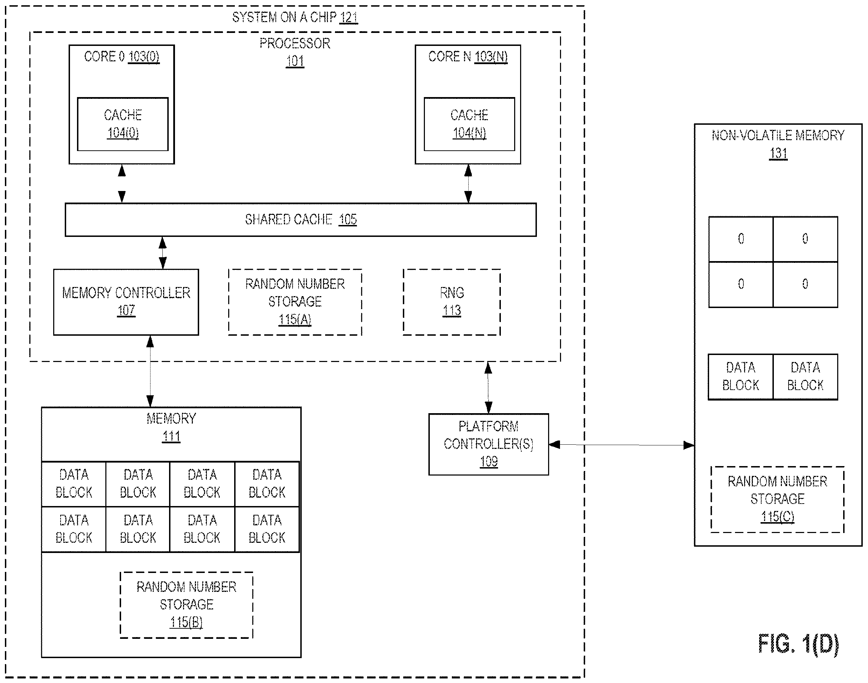

FIG. 1(D) illustrates a portion of the non-volatile memory 131 being initialized to zero.

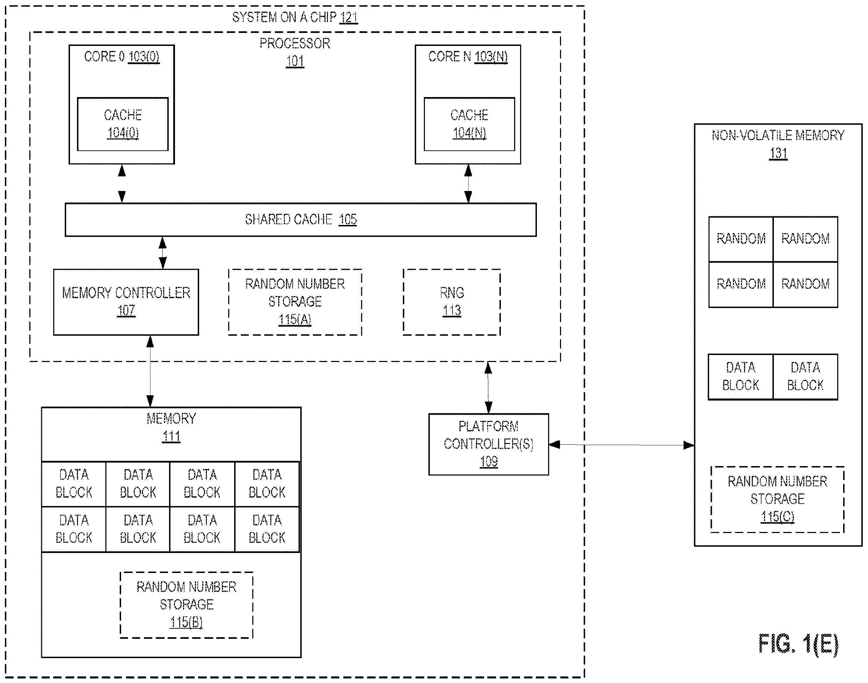

FIG. 1(E) illustrates a portion of the non-volatile memory 131 being initialized to random values. These random values may come from the random number storage 115(A) or 115(C) depending on the implementation.

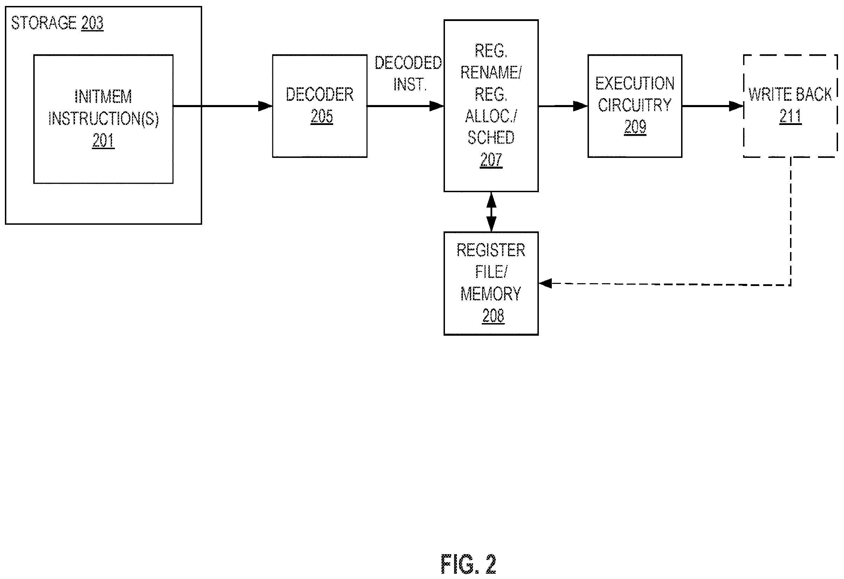

**FIG. 2** illustrates examples of hardware to process an instruction such as a memory initialization (MEMINIT) instruction. In some examples, this hardware represents aspects of a core. As illustrated, storage 203 stores an MEMINIT instruction 201 to be executed.

The instruction 201 is received by decode circuitry 205. For example, the decode circuitry 205 receives this instruction from fetch logic/circuitry. The instruction includes fields for an opcode, first and second sources, and a destination. In some examples, the sources and destination are registers, and in other examples one or more are memory locations. In some examples, the opcode details which arithmetic operation is to be performed.

More detailed examples of at least one instruction format will be detailed later. The decode circuitry 205 decodes the instruction into one or more operations. In some examples, this decoding includes generating a plurality of micro-operations to be performed by execution circuitry (such as execution circuitry 209). The decode circuitry 205 also decodes instruction prefixes.

In some examples, register renaming, register allocation, and/or scheduling circuitry 207 provides functionality for one or more of: 1) renaming logical operand values to physical operand values (e.g., a register alias table in some examples), 2) allocating status bits and flags to the decoded instruction, and 3) scheduling the decoded instruction for execution on execution circuitry out of an instruction pool (e.g., using a reservation station in some examples).

Registers (register file) and/or memory 208 store data as operands of the instruction to be operated on by execution circuitry 209. Exemplary register types include packed data registers, general purpose registers, and floating-point registers.

Execution circuitry 209 executes the decoded instruction(s) to inform a memory controller (e.g., 107) or platform controller (e.g., 109) to perform an initialization operation. Exemplary detailed execution circuitry is shown in FIGS. 'ISAA, 7, etc. The execution of the decoded instruction causes the execution circuitry to generate a command to initialize memory as indicated by the opcode of the instruction and/or the opcode of the instruction and operands of the instruction. Note that in some examples the execution is considered to cause an initialization without a separate command.

In some examples, retirement/write back circuitry 211 architecturally commits the destination register into the registers or memory 208 and retires the instruction.

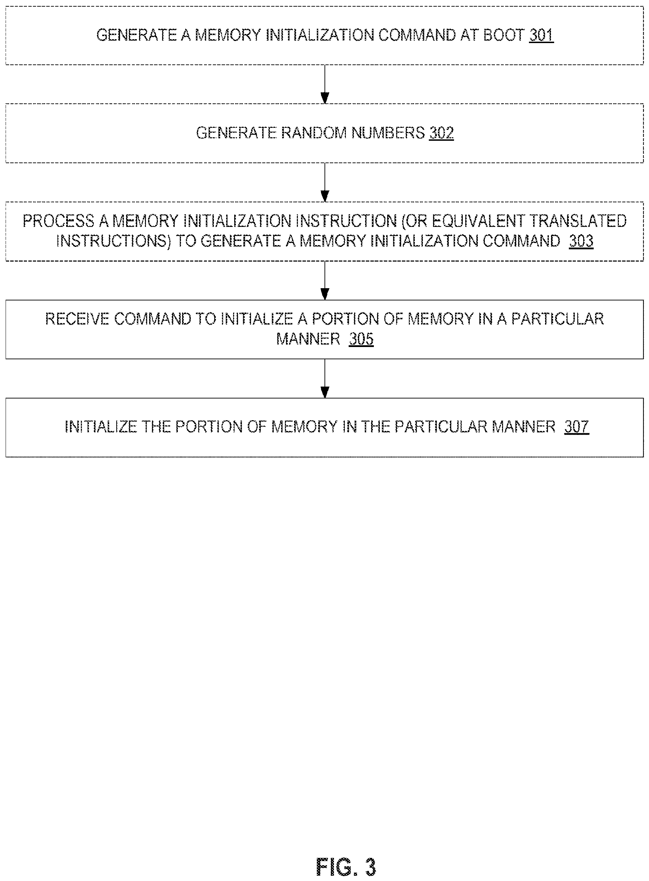

FIG. 3 illustrates examples of a method for memory initialization. In some examples, a memory initialization command is generated at boot at 301. The memory initialization command will be fed to the memory controller (e.g., 107) coupled to memory to be initialized and/or to a platform controller (e.g., 109) couple to non-volatile memory to be initialized. The command indicates what memory (or portion thereof) is to be initiated and how that memory is to be initiated (e.g., zeroed or written with random data). Note that either of those indications may be implicit.

In some examples, a plurality of random numbers is generated and stored at 302. This may occur during boot, during downtime within a processor, etc. This generation allows for the initialization to random numbers have little or no time penalty. In some examples, the random numbers are stored in, or near, the memory to be initialized.

In some examples, a memory initialization instruction (or equivalent translated instructions) is processed to generate a memory initialization command at 303. In these examples, an instruction such as those detailed below is processed to generate a command that indicates what memory (or portion thereof) is to be initiated and how that memory is to be initiated (e.g., zeroed or written with random data) by a memory controller or a platform controller. Note that either of those statements may be implicit. Note that in some examples the execution is considered to cause an initialization without a separate command.

A command to initialize a portion of memory in a particular manner is received by a memory controller or a platform controller at 305 in some examples. The portion of memory is initialized in the particular manner according to the command or instruction execution at 307. This initialization is caused by the memory controller or platform controller that received the command.

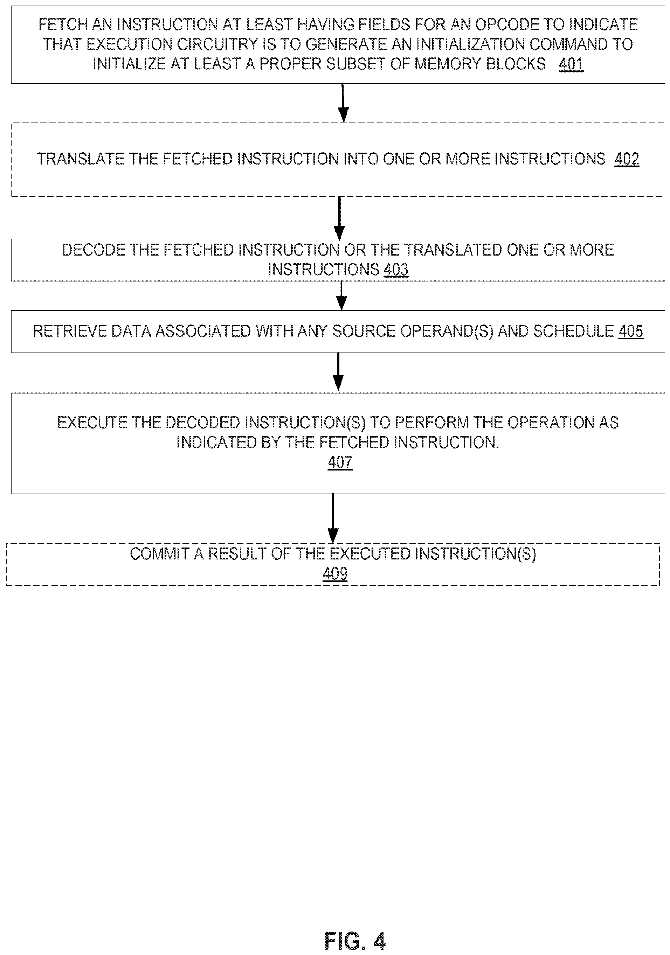

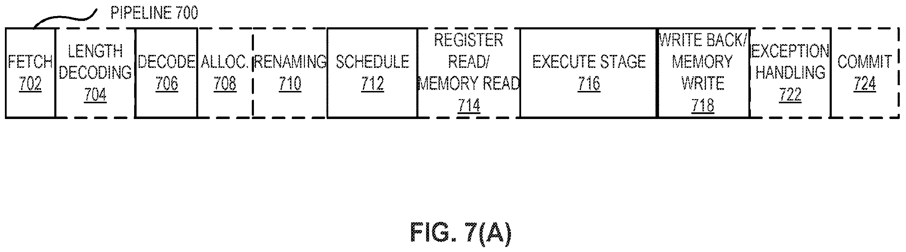

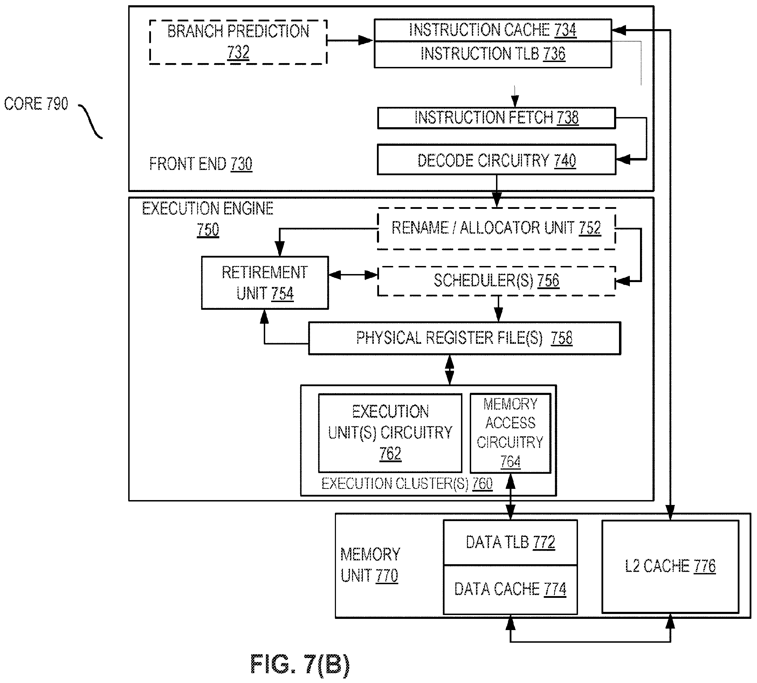

**FIG. 4** illustrates examples of a method to process a memory initialization instruction. In some examples, a processor core as shown in FIG. 7(B), a pipeline as detailed below, etc. performs this method to inform a memory controller (e.g., 107) or platform controller (e.g., 109) to perform the initialization. In other examples, a binary translation layer performs aspects of the method and a processor core performs other aspects of the method.

At 401, a single memory initialization instruction is fetched. For example, a memory initialization instruction is fetched. The memory initialization instruction may come in many different forms depending on the implementation.

An example of a format for a memory initialization instruction is MEMINT. In some examples, MEMINT is the opcode mnemonic of the instruction. The MEMINT instruction, when executed, causes a predetermined subset of memory to be initialized. For example, L0 cache, L1 cache, etc. The predetermined subset of memory may be initialized is as 0s or random data depending upon the implementation.

An example of a format for a memory initialization instruction is MEMINT IMM. In some examples, MEMINT is the opcode mnemonic of the instruction. The MEMINT instruction, when executed, causes a predetermined subset of memory to be initialized as set in the immediate (IMM). For example, in some examples, IMM = 0 indicates to initialize to 0, IMM = 1 indicates to initialize with random data. Of course, the opposite, or other convention may be used. Note that in some examples a different random data value is used per set of blocks. In other examples, the same random value is used in all sets of blocks.

An example of a format for a memory initialization instruction is MEMINT0. In some examples, MEMINT0 is the opcode mnemonic of the instruction. The MEMINT0 instruction, when executed, causes a predetermined subset of memory to be initialized. For example, L0 cache, L1 cache, etc. The predetermined subset of memory is initialized is as 0s.

An example of a format for a memory initialization instruction is MEMINTRDM. In some examples, MEMINTRDM is the opcode mnemonic of the instruction. The MEMINTRDM instruction, when executed, causes a predetermined subset of memory to be initialized. For example, L0 cache, L1 cache, etc. The predetermined subset of memory is initialized with random data. Note that in some examples a different random data value is used per set of blocks. In other examples, the same random value is used in all sets of blocks.

An example of a format for a memory initialization instruction is MEMINT{LX}. In some examples, MEMINT{LX} is the opcode mnemonic of the instruction where LX indicates a level of memory to initialize. For example, L0 = L0 cache, L1 = L1 cache, L2 = L2 cache, LLC = LLC cache, LM = random access memory, LVM = non-volatile memory, XMM = all 128-bit vector registers, YMM = all 256-bit vector registers, etc. The indicated subset of memory may be initialized is as 0s or random data depending upon the implementation. Note that in some examples a different random data value is used per set of blocks. In other examples, the same random value is used in all sets of blocks.

An example of a format for a memory initialization instruction is MEMINT{LX} IMM. In some examples, MEMINT{LX} is the opcode mnemonic of the instruction where LX indicates a level of memory to initialize according to a value in the immediate. For example, L0 = L0 cache, L1 = L1 cache, L2 = L2 cache, LLC = LLC cache, LM = random access memory, LVM = non-volatile memory, etc. For example, in some examples, IMM = 0 indicates to initialize to 0, IMM = 1 indicates to initialize with random data. Of course, the opposite, or other convention may be used. Note that in some examples a different random data value is used per set of blocks. In other examples, the same random value is used in all sets of blocks.

An example of a format for a memory initialization instruction is MEMINT{LX} SRC. In some examples, MEMINT{LX} is the opcode mnemonic of the instruction where LX indicates a level of memory to initialize according to a value in the source SRC (which is indicated by one or more fields and may be a register or memory location). For example, L0 = L0 cache, L1 = L1 cache, L2 = L2 cache, LLC = LLC cache, LM = random access memory, LVM = non-volatile memory, etc.). For example, in some examples, value in SRC = 0 indicates to initialize to 0, value in SRC = 1 indicates to initialize with random data. Of course, the opposite, or other convention may be used. Note that in some examples a different random data value is used per set of blocks. In other examples, the same random value is used in all sets of blocks.

An example of a format for a memory initialization instruction is MEMINT SRC1, SRC2. In some examples, MEMINT is the opcode mnemonic of the instruction where SRC1 is a location that stores an indication of a level of memory to initialize. For example, L0 = L0 cache, L1 = L1 cache, L2 = L2 cache, LLC = LLC cache, LM = random access memory, LVM = non-volatile memory, etc. SRC2 is a location that stores the type of initialization. For example, in some examples, SRC2 = 0 indicates to initialize to 0, SRC2 = 1 indicates to initialize with random data. Of course, the opposite, or other convention may be used. Note that in some examples a different random data value is used per set of blocks. In other examples, the same random value is used in all sets of blocks.

An example of a format for a memory initialization instruction is MEMINT DEST, SRC1, SRC2 IMM. In some examples, MEMINT is the opcode mnemonic of the instruction where SRC1 is a location that stores an indication of a level of memory to initialize. For example, L0 = L0 cache, L1 = L1 cache, L2 = L2 cache, LLC = LLC cache, LM = random access memory, LVM = non-volatile memory, etc. DEST indicates an initial memory location to write and SRC2 provides a size of memory to be written. IMM indicates the type of initialization. For example, in some examples, IMM = 0 indicates to initialize to 0, IMM = 1 indicates to initialize with random data. Of course, the opposite, or other convention may be used. Note that in some examples a different random data value is used per set of blocks. In other examples, the same random value is used in all sets of blocks.

An example of a format for a memory initialization instruction is MEMINT{LX} DEST, SRC1, SRC2. In some examples, MEMINT{LX} is the opcode mnemonic of the instruction where LX indicates a level of memory to initialize. For example, L0 = L0 cache, L1 = L1 cache, L2 = L2 cache, LLC = LLC cache, LM = random access memory, LVM = non-volatile memory, etc. DEST indicates an initial memory location to write and SRC1 provides a size of memory to be written. SRC2 indicates the type of initialization.

An example of a format for a memory initialization instruction is MEMINT{LX} DEST, SRC1 IMM. In some examples, MEMINT{LX} is the opcode mnemonic of the instruction where LX indicates a level of memory to initialize. For example, L0 = L0 cache, L1 = L1 cache, L2 = L2 cache, LLC = LLC cache, LM = random access memory, LVM = non-volatile memory, etc. DEST indicates an initial memory location to write and SRC1 provides a size of memory to be written. IMM indicates the type of initialization.

An example of a format for a memory initialization instruction is MEMINT{LX}{TYPE} DEST, SRC1, SRC2. In some examples, MEMINT{LX}{TYPE} is the opcode mnemonic of the instruction where LX indicates a level of memory to initialize. For example, L0 = L0 cache, L1 = L1 cache, L2 = L2 cache, LLC = LLC cache, LM = random access memory, LVM = non-volatile memory, etc. DEST indicates an initial memory location to write and SRC1 provides a size of memory to be written. TYPE indicates the type of initialization.

An example of a format for a memory initialization instruction is MEMINT{LX}{TYPE}. In some examples, MEMINT{LX}{TYPE} is the opcode mnemonic of the instruction where LX indicates a level of memory to initialize and TYPE indicates the type of initialization.

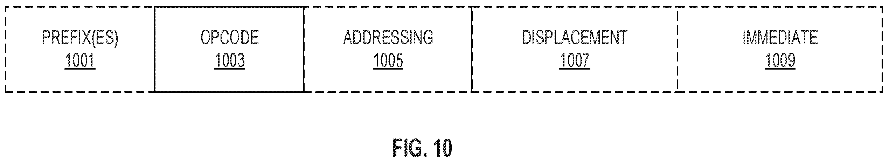

Examples of instruction formats are shown in FIGS. 10-15. In some examples, the opcode of the instruction is found in, for example, field 1003 and any used immediate is found in 1009. In some examples, the type of write to perform is dictated by a prefix. A source is typically indicated using addressing field 1005 such as using aspects of the mod R/M byte 1102 like the register field 1144 to indicate a register as a source, the r/m field 1146 as another source, etc. Note that sources can be registers and/or memory.

In some examples, the fetched instruction of the first instruction set is translated into one or more instructions of a second instruction set at 402.

The fetched instruction, or the one or more translated instructions of the second instruction set, is/are decoded at 403. In some examples, the translation and decoding are merged.

Data values associated with the source operand(s) of the decoded instruction(s) are retrieved and the instruction(s) scheduled at 405. For example, when one or more of the source operands are memory operands, the data from the indicated memory location is retrieved.

At 407, the decoded instruction(s) is/are executed by execution circuitry (hardware) such as that detailed herein according to the opcode, etc. of the fetched instruction.

In some examples, the instruction(s) is/are committed or retired at 409.

Exemplary architectures, instruction formats, etc. that may be used to embody the above are detailed below.

### Exemplary Computer Architectures

Detailed below are describes of exemplary computer architectures. Other system designs and configurations known in the arts for laptops, desktops, handheld PCs, personal digital assistants, engineering workstations, servers, network devices, network hubs, switches, embedded processors, digital signal processors (DSPs), graphics devices, video game devices, set-top boxes, micro controllers, cell phones, portable media players, handheld devices, and various other electronic devices, are also suitable. In general, a huge variety of systems or electronic devices capable of incorporating a processor and/or other execution logic as disclosed herein are generally suitable.

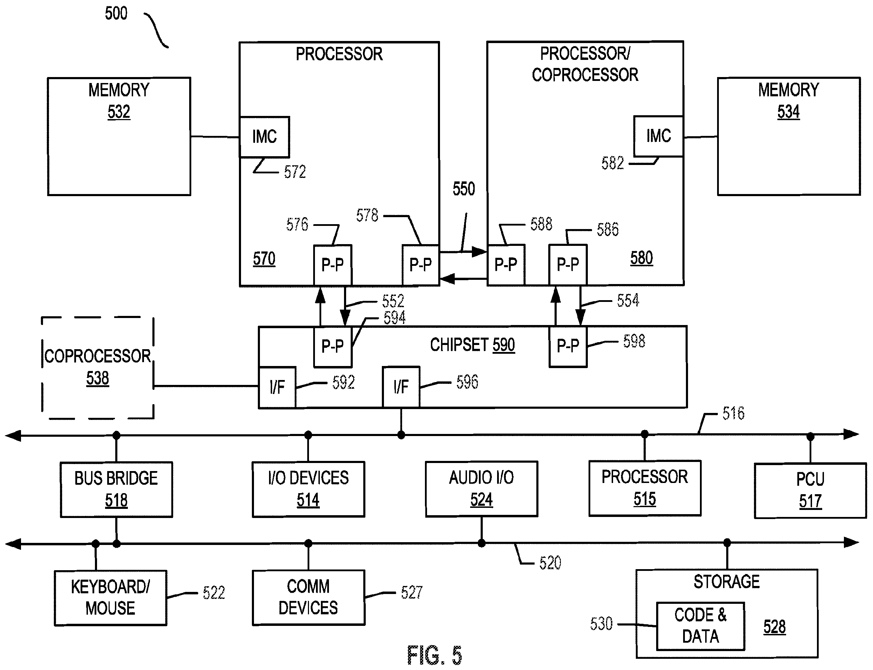

**FIG. 5** illustrates examples of an exemplary system. Multiprocessor system 500 is a point-to-point interconnect system and includes a plurality of processors including a first processor 570 and a second processor 580 coupled via a point-to-point interconnect 550. In some examples, the first processor 570 and the second processor 580 are homogeneous. In some examples, first processor 570 and the second processor 580 are heterogenous.

Processors 570 and 580 are shown including integrated memory controller (IMC) units circuitry 572 and 582, respectively. Processor 570 also includes as part of its interconnect controller units point-to-point (P-P) interfaces 576 and 578; similarly, second processor 580 includes P-P interfaces 586 and 588. Processors 570, 580 may exchange information via the point-to-point (P-P) interconnect 550 using P-P interface circuits 578, 588. IMCs 572 and 582 couple the processors 570, 580 to respective memories, namely a memory 532 and a memory 534, which may be portions of main memory locally attached to the respective processors.

Processors 570, 580 may each exchange information with a chipset 590 via individual P-P interconnects 552, 554 using point to point interface circuits 576, 594, 586, 598. Chipset 590 may optionally exchange information with a coprocessor 538 via a high-performance interface 592. In some examples, the coprocessor 538 is a special-purpose processor, such as, for example, a high-throughput MIC processor, a network or communication processor, compression engine, graphics processor, GPGPU, embedded processor, or the like.

A shared cache (not shown) may be included in either processor 570, 580 or outside of both processors, yet connected with the processors via P-P interconnect, such that either or both processors' local cache information may be stored in the shared cache if a processor is placed into a low power mode.

Chipset 590 may be coupled to a first interconnect 516 via an interface 596. In some examples, first interconnect 516 may be a Peripheral Component Interconnect (PCI) interconnect, or an interconnect such as a PCI Express interconnect or another I/O interconnect. In some examples, one of the interconnects couples to a power control unit (PCU) 517, which may include circuitry, software, and/or firmware to perform power management operations with regard to the processors 570, 580 and/or co-processor 538. PCU 517 provides control information to a voltage regulator to cause the voltage regulator to generate the appropriate regulated voltage. PCU 517 also provides control information to control the operating voltage generated. In various examples, PCU 517 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 517 is illustrated as being present as logic separate from the processor 570 and/or processor 580. In other cases, PCU 517 may execute on a given one or more of cores (not shown) of processor 570 or 580. In some cases, PCU 517 may be implemented as a microcontroller (dedicated or general-purpose) or other control logic configured to execute its own dedicated power management code, sometimes referred to as P-code. In yet other examples, power management operations to be performed by PCU 517 may be implemented externally to a processor, such as by way of a separate power management integrated circuit (PMIC) or another component external to the processor. In yet other examples, power management operations to be performed by PCU 517 may be implemented within BIOS or other system software.

Various I/O devices 514 may be coupled to first interconnect 516, along with an interconnect (bus) bridge 518 which couples first interconnect 516 to a second interconnect 520. In some examples, one or more additional processor(s) 515, such as coprocessors, high-throughput MIC processors, GPGPU's, accelerators (such as, e.g., graphics accelerators or digital signal processing (DSP) units), field programmable gate arrays (FPGAs), or any other processor, are coupled to first interconnect 516. In some examples, second interconnect 520 may be a low pin count (LPC) interconnect. Various devices may be coupled to second interconnect 520 including, for example, a keyboard and/or mouse 522, communication devices 527 and a storage unit circuitry 528. Storage unit circuitry 528 may be a disk drive or other mass storage device which may include instructions/code and data 530, in some examples. Further, an audio I/O 524 may be coupled to second interconnect 520. Note that other architectures than the point-to-point architecture described above are possible. For example, instead of the point-to-point architecture, a system such as multiprocessor system 500 may implement a multi-drop interconnect or other such architecture.

### Exemplary Core Architectures, Processors, and Computer Architectures

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput). Such different processors lead to different computer system architectures, which may include: 1) the coprocessor on a separate chip from the CPU; 2) the coprocessor on a separate die in the same package as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip that may include on the same die as the described CPU (sometimes referred to as the application core(s) or application processor(s)), the above described coprocessor, and additional functionality. Exemplary core architectures are described next, followed by descriptions of exemplary processors and computer architectures.

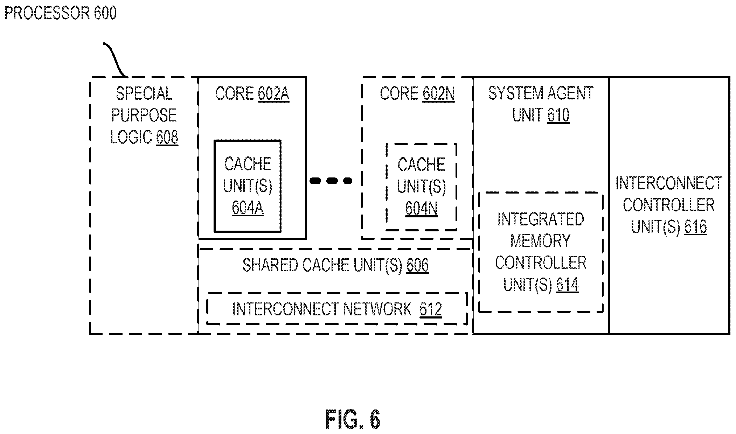

**FIG. 6** illustrates a block diagram of examples of a processor 600 that may have more than one core, may have an integrated memory controller, and may have integrated graphics. The solid lined boxes illustrate a processor 600 with a single core 602A, a system agent 610, a set of one or more interconnect controller units circuitry 616, while the optional addition of the dashed lined boxes illustrates an alternative processor 600 with multiple cores 602(A)-(N), a set of one or more integrated memory controller unit(s) circuitry 614 in the system agent unit circuitry 610, and special purpose logic 608, as well as a set of one or more interconnect controller units circuitry 616. Note that the processor 600 may be one of the processors 570 or 580, or co-processor 538 or 515 of **FIG. 5****.**

Thus, different implementations of the processor 600 may include: 1) a CPU with the special purpose logic 608 being integrated graphics and/or scientific (throughput) logic (which may include one or more cores, not shown), and the cores 602(A)-(N) being one or more general purpose cores (e.g., general purpose in-order cores, general purpose out-of-order cores, or a combination of the two); 2) a coprocessor with the cores 602(A)-(N) being a large number of special purpose cores intended primarily for graphics and/or scientific (throughput); and 3) a coprocessor with the cores 602(A)-(N) being a large number of general purpose in-order cores. Thus, the processor 600 may be a general-purpose processor, coprocessor or special-purpose processor, such as, for example, a network or communication processor, compression engine, graphics processor, GPGPU (general purpose graphics processing unit circuitry), a high-throughput many integrated core (MIC) coprocessor (including 30 or more cores), embedded processor, or the like. The processor may be implemented on one or more chips. The processor 600 may be a part of and/or may be implemented on one or more substrates using any of a number of process technologies, such as, for example, BiCMOS, CMOS, or NMOS.

A memory hierarchy includes one or more levels of cache unit(s) circuitry 604(A)-(N) within the cores 602(A)-(N), a set of one or more shared cache units circuitry 606, and external memory (not shown) coupled to the set of integrated memory controller units circuitry 614. The set of one or more shared cache units circuitry 606 may include one or more mid-level caches, such as level 2 (L2), level 3 (L3), level 4 (L4), or other levels of cache, such as a last level cache (LLC), and/or combinations thereof. While in some examples ring-based interconnect network circuitry 612 interconnects the special purpose logic 608 (e.g., integrated graphics logic), the set of shared cache units circuitry 606, and the system agent unit circuitry 610, alternative examples use any number of well-known techniques for interconnecting such units. In some examples, coherency is maintained between one or more of the shared cache units circuitry 606 and cores 602(A)-(N).

In some examples, one or more of the cores 602(A)-(N) are capable of multi-threading. The system agent unit circuitry 610 includes those components coordinating and operating cores 602(A)-(N). The system agent unit circuitry 610 may include, for example, power control unit (PCU) circuitry and/or display unit circuitry (not shown). The PCU may be or may include logic and components needed for regulating the power state of the cores 602(A)-(N) and/or the special purpose logic 608 (e.g., integrated graphics logic). The display unit circuitry is for driving one or more externally connected displays.

The cores 602(A)-(N) may be homogenous or heterogeneous in terms of architecture instruction set; that is, two or more of the cores 602(A)-(N) may be capable of executing the same instruction set, while other cores may be capable of executing only a subset of that instruction set or a different instruction set.

### Exemplary Core Architectures

### In-order and out-of-order core block diagram

**FIG. 7(A)** is a block diagram illustrating both an exemplary in-order pipeline and an exemplary register renaming, out-of-order issue/execution pipeline according to examples. **FIG. 7(B)** is a block diagram illustrating both an example of an in-order architecture core and an exemplary register renaming, out-of-order issue/execution architecture core to be included in a processor according to examples. The solid lined boxes in **FIGS. 7(A)****-(B)** illustrate the in-order pipeline and in-order core, while the optional addition of the dashed lined boxes illustrates the register renaming, out-of-order issue/execution pipeline and core. Given that the in-order aspect is a subset of the out-of-order aspect, the out-of-order aspect will be described.

In **FIG. 7(A)**, a processor pipeline 700 includes a fetch stage 702, an optional length decode stage 704, a decode stage 706, an optional allocation stage 708, an optional renaming stage 710, a scheduling (also known as a dispatch or issue) stage 712, an optional register read/memory read stage 714, an execute stage 716, a write back/memory write stage 718, an optional exception handling stage 722, and an optional commit stage 724. One or more operations can be performed in each of these processor pipeline stages. For example, during the fetch stage 702, one or more instructions are fetched from instruction memory, during the decode stage 706, the one or more fetched instructions may be decoded, addresses (e.g., load store unit (LSU) addresses) using forwarded register ports may be generated, and branch forwarding (e.g., immediate offset or an link register (LR)) may be performed. In one example, the decode stage 706 and the register read/memory read stage 714 may be combined into one pipeline stage. In one example, during the execute stage 716, the decoded instructions may be executed, LSU address/data pipelining to an Advanced Microcontroller Bus (AHB) interface may be performed, multiply and add operations may be performed, arithmetic operations with branch results may be performed, etc.

By way of example, the exemplary register renaming, out-of-order issue/execution core architecture may implement the pipeline 700 as follows: 1) the instruction fetch 738 performs the fetch and length decoding stages 702 and 704; 2) the decode unit circuitry 740 performs the decode stage 706; 3) the rename/allocator unit circuitry 752 performs the allocation stage 708 and renaming stage 710; 4) the scheduler unit(s) circuitry 756 performs the schedule stage 712; 5) the physical register file(s) unit(s) circuitry 758 and the memory unit circuitry 770 perform the register read/memory read stage 714; the execution cluster 760 perform the execute stage 716; 6) the memory unit circuitry 770 and the physical register file(s) unit(s) circuitry 758 perform the write back/memory write stage 718; 7) various units (unit circuitry) may be involved in the exception handling stage 722; and 8) the retirement unit circuitry 754 and the physical register file(s) unit(s) circuitry 758 perform the commit stage 724.

**FIG. 7(B)** shows processor core 790 including front-end unit circuitry 730 coupled to an execution engine unit circuitry 750, and both are coupled to a memory unit circuitry 770. The core 790 may be a reduced instruction set computing (RISC) core, a complex instruction set computing (CISC) core, a very long instruction word (VLIW) core, or a hybrid or alternative core type. As yet another option, the core 790 may be a special-purpose core, such as, for example, a network or communication core, compression engine, coprocessor core, general purpose computing graphics processing unit (GPGPU) core, graphics core, or the like.

The front end unit circuitry 730 may include branch prediction unit circuitry 732 coupled to an instruction cache unit circuitry 734, which is coupled to an instruction translation lookaside buffer (TLB) 736, which is coupled to instruction fetch unit circuitry 738, which is coupled to decode unit circuitry 740. In one example, the instruction cache unit circuitry 734 is included in the memory unit circuitry 770 rather than the front-end unit circuitry 730. The decode unit circuitry 740 (or decoder) may decode instructions, and generate as an output one or more micro-operations, micro-code entry points, microinstructions, other instructions, or other control signals, which are decoded from, or which otherwise reflect, or are derived from, the original instructions. The decode unit circuitry 740 may further include an address generation unit circuitry (AGU, not shown). In one example, the AGU generates an LSU address using forwarded register ports, and may further perform branch forwarding (e.g., immediate offset branch forwarding, LR register branch forwarding, etc.). The decode unit circuitry 740 may be implemented using various different mechanisms. Examples of suitable mechanisms include, but are not limited to, look-up tables, hardware implementations, programmable logic arrays (PLAs), microcode read only memories (ROMs), etc. In one example, the core 790 includes a microcode ROM (not shown) or other medium that stores microcode for certain macroinstructions (e.g., in decode unit circuitry 740 or otherwise within the front end unit circuitry 730). In one example, the decode unit circuitry 740 includes a micro-operation (micro-op) or operation cache (not shown) to hold/cache decoded operations, micro-tags, or micro-operations generated during the decode or other stages of the processor pipeline 700. The decode unit circuitry 740 may be coupled to rename/allocator unit circuitry 752 in the execution engine unit circuitry 750.

The execution engine circuitry 750 includes the rename/allocator unit circuitry 752 coupled to a retirement unit circuitry 754 and a set of one or more scheduler(s) circuitry 756. The scheduler(s) circuitry 756 represents any number of different schedulers, including reservations stations, central instruction window, etc. In some examples, the scheduler(s) circuitry 756 can include arithmetic logic unit (ALU) scheduler/scheduling circuitry, ALU queues, arithmetic generation unit (AGU) scheduler/scheduling circuitry, AGU queues, etc. The scheduler(s) circuitry 756 is coupled to the physical register file(s) circuitry 758. Each of the physical register file(s) circuitry 758 represents one or more physical register files, different ones of which store one or more different data types, such as scalar integer, scalar floating-point, packed integer, packed floating-point, vector integer, vector floating-point, status (e.g., an instruction pointer that is the address of the next instruction to be executed), etc. In one example, the physical register file(s) unit circuitry 758 includes vector registers unit circuitry, writemask registers unit circuitry, and scalar register unit circuitry. These register units may provide architectural vector registers, vector mask registers, general-purpose registers, etc. The physical register file(s) unit(s) circuitry 758 is overlapped by the retirement unit circuitry 754 (also known as a retire queue or a retirement queue) to illustrate various ways in which register renaming and out-of-order execution may be implemented (e.g., using a reorder buffer(s) (ROB(s)) and a retirement register file(s); using a future file(s), a history buffer(s), and a retirement register file(s); using a register maps and a pool of registers; etc.). The retirement unit circuitry 754 and the physical register file(s) circuitry 758 are coupled to the execution cluster(s) 760. The execution cluster(s) 760 includes a set of one or more execution units circuitry 762 and a set of one or more memory access circuitry 764. The execution units circuitry 762 may perform various arithmetic, logic, floating-point or other types of operations (e.g., shifts, addition, subtraction, multiplication) and on various types of data (e.g., scalar floating-point, packed integer, packed floating-point, vector integer, vector floating-point). While some examples may include a number of execution units or execution unit circuitry dedicated to specific functions or sets of functions, other examples may include only one execution unit circuitry or multiple execution units/execution unit circuitry that all perform all functions. The scheduler(s) circuitry 756, physical register file(s) unit(s) circuitry 758, and execution cluster(s) 760 are shown as being possibly plural because certain examples create separate pipelines for certain types of data/operations (e.g., a scalar integer pipeline, a scalar floating-point/packed integer/packed floating-point/vector integer/vector floating-point pipeline, and/or a memory access pipeline that each have their own scheduler circuitry, physical register file(s) unit circuitry, and/or execution cluster - and in the case of a separate memory access pipeline, certain examples are implemented in which only the execution cluster of this pipeline has the memory access unit(s) circuitry 764). It should also be understood that where separate pipelines are used, one or more of these pipelines may be out-of-order issue/execution and the rest in-order.

In some examples, the execution engine unit circuitry 750 may perform load store unit (LSU) address/data pipelining to an Advanced Microcontroller Bus (AHB) interface (not shown), and address phase and writeback, data phase load, store, and branches.

The set of memory access circuitry 764 is coupled to the memory unit circuitry 770, which includes data TLB unit circuitry 772 coupled to a data cache circuitry 774 coupled to a level 2 (L2) cache circuitry 776. In one example, the memory access units circuitry 764 may include a load unit circuitry, a store address unit circuit, and a store data unit circuitry, each of which is coupled to the data TLB circuitry 772 in the memory unit circuitry 770. The instruction cache circuitry 734 is further coupled to a level 2 (L2) cache unit circuitry 776 in the memory unit circuitry 770. In one example, the instruction cache 734 and the data cache 774 are combined into a single instruction and data cache (not shown) in L2 cache unit circuitry 776, a level 3 (L3) cache unit circuitry (not shown), and/or main memory. The L2 cache unit circuitry 776 is coupled to one or more other levels of cache and eventually to a main memory.

The core 790 may support one or more instructions sets (e.g., the x86 instruction set (with some extensions that have been added with newer versions); the MIPS instruction set; the ARM instruction set (with optional additional extensions such as NEON)), including the instruction(s) described herein. In one example, the core 790 includes logic to support a packed data instruction set extension (e.g., AVX1, AVX2), thereby allowing the operations used by many multimedia applications to be performed using packed data.

### Exemplary Execution Unit(s) Circuitry

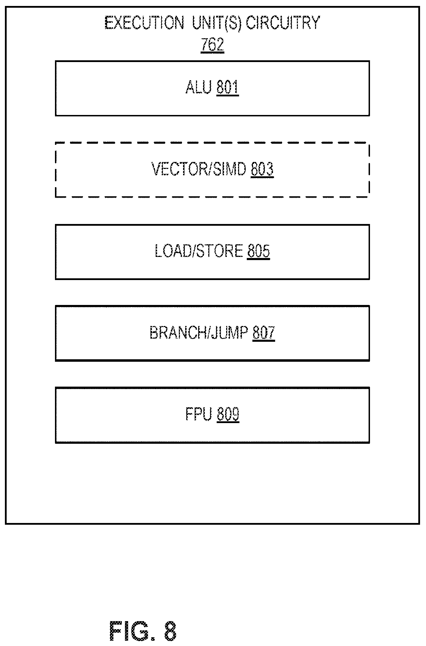

**FIG. 8** illustrates examples of execution unit(s) circuitry, such as execution unit(s) circuitry 762 of FIG. 7(B). As illustrated, execution unit(s) circuity 762 may include one or more ALU circuits 801, vector/SIMD unit circuits 803, load/store unit circuits 805, and/or branch/jump unit circuits 807. ALU circuits 801 perform integer arithmetic and/or Boolean operations. Vector/SIMD unit circuits 803 perform vector/SIMD operations on packed data (such as SIMD/vector registers). Load/store unit circuits 805 execute load and store instructions to load data from memory into registers or store from registers to memory. Load/store unit circuits 805 may also generate addresses. Branch/jump unit circuits 807 cause a branch or jump to a memory address depending on the instruction. Floating-point unit (FPU) circuits 809 perform floating-point arithmetic. The width of the execution unit(s) circuitry 762 varies depending upon the example and can range from 16-bit to 1,024-bit. In some examples, two or more smaller execution units are logically combined to form a larger execution unit (e.g., two 128-bit execution units are logically combined to form a 256-bit execution unit).

### Exemplary Register Architecture

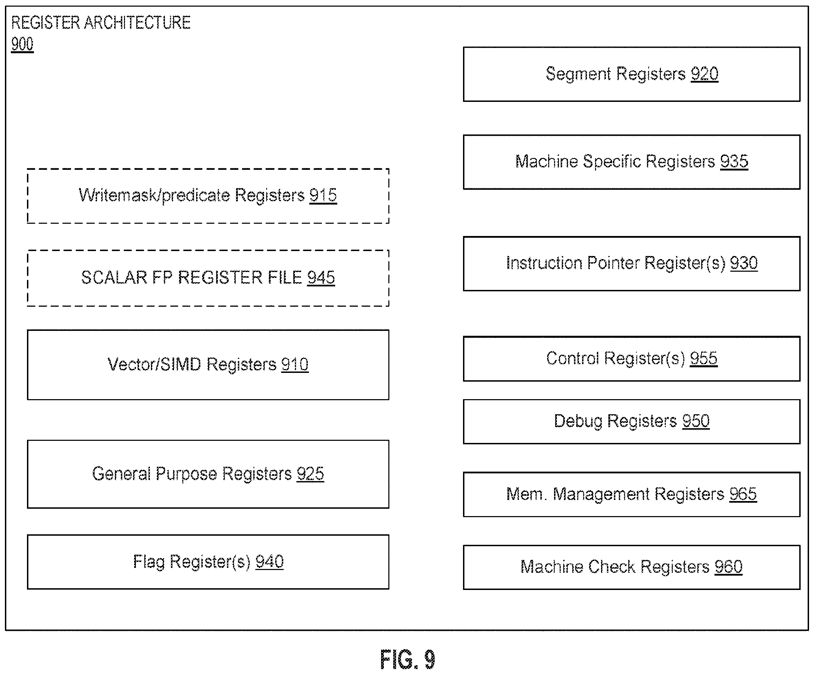

**FIG. 9** is a block diagram of a register architecture 900 according to some examples. As illustrated, there are vector/SIMD registers 910 that vary from 128-bit to 1,024 bits width. In some examples, the vector/SIMD registers 910 are physically 512-bits and, depending upon the mapping, only some of the lower bits are used. For example, in some examples, the vector/SIMD registers 910 are ZMM registers which are 512 bits: the lower 256 bits are used for YMM registers and the lower 128 bits are used for XMM registers. As such, there is an overlay of registers. In some examples, a vector length field selects between a maximum length and one or more other shorter lengths, where each such shorter length is half the length of the preceding length. Scalar operations are operations performed on the lowest order data element position in a ZMM/YMM/XMM register; the higher order data element positions are either left the same as they were prior to the instruction or zeroed depending on the example.

In some examples, the register architecture 900 includes writemask/predicate registers 915. For example, in some examples, there are 8 writemask/predicate registers (sometimes called k0 through k7) that are each 16-bit, 32-bit, 64-bit, or 128-bit in size. Writemask/predicate registers 915 may allow for merging (e.g., allowing any set of elements in the destination to be protected from updates during the execution of any operation) and/or zeroing (e.g., zeroing vector masks allow any set of elements in the destination to be zeroed during the execution of any operation). In some examples, each data element position in a given writemask/predicate register 915 corresponds to a data element position of the destination. In other examples, the writemask/predicate registers 915 are scalable and consists of a set number of enable bits for a given vector element (e.g., 8 enable bits per 64-bit vector element).

The register architecture 900 includes a plurality of general-purpose registers 925. These registers may be 16-bit, 32-bit, 64-bit, etc. and can be used for scalar operations. In some examples, these registers are referenced by the names RAX, RBX, RCX, RDX, RBP, RSI, RDI, RSP, and R8 through R15.

In some examples, the register architecture 900 includes scalar floating-point register 945 which is used for scalar floating-point operations on 32/64/80-bit floating-point data using the x87 instruction set extension or as MMX registers to perform operations on 64-bit packed integer data, as well as to hold operands for some operations performed between the MMX and XMM registers.

One or more flag registers 940 (e.g., EFLAGS, RFLAGS, etc.) store status and control information for arithmetic, compare, and system operations. For example, the one or more flag registers 940 may store condition code information such as carry, parity, auxiliary carry, zero, sign, and overflow. In some examples, the one or more flag registers 940 are called program status and control registers.

Segment registers 920 contain segment points for use in accessing memory. In some examples, these registers are referenced by the names CS, DS, SS, ES, FS, and GS.

Machine specific registers (MSRs) 935 control and report on processor performance. Most MSRs 935 handle system-related functions and are not accessible to an application program. Machine check registers 960 consist of control, status, and error reporting MSRs that are used to detect and report on hardware errors.

One or more instruction pointer register(s) 930 store an instruction pointer value. Control register(s) 955 (e.g., CR0-CR4) determine the operating mode of a processor (e.g., processor 570, 580, 538, 515, and/or 600) and the characteristics of a currently executing task. Debug registers 950 control and allow for the monitoring of a processor or core's debugging operations.

Memory management registers 965 specify the locations of data structures used in protected mode memory management. These registers may include a GDTR, IDRT, task register, and a LDTR register.

Alternative examples may use wider or narrower registers. Additionally, alternative examples may use more, less, or different register files and registers.

### Instruction Sets

An instruction set architecture (ISA) may include one or more instruction formats. A given instruction format may define various fields (e.g., number of bits, location of bits) to specify, among other things, the operation to be performed (e.g., opcode) and the operand(s) on which that operation is to be performed and/or other data field(s) (e.g., mask). Some instruction formats are further broken down though the definition of instruction templates (or sub-formats). For example, the instruction templates of a given instruction format may be defined to have different subsets of the instruction format's fields (the included fields are typically in the same order, but at least some have different bit positions because there are less fields included) and/or defined to have a given field interpreted differently. Thus, each instruction of an ISA is expressed using a given instruction format (and, if defined, in a given one of the instruction templates of that instruction format) and includes fields for specifying the operation and the operands. For example, an exemplary ADD instruction has a specific opcode and an instruction format that includes an opcode field to specify that opcode and operand fields to select operands (source1/destination and source2); and an occurrence of this ADD instruction in an instruction stream will have specific contents in the operand fields that select specific operands.

### Exemplary Instruction Formats

Examples of the instruction(s) described herein may be embodied in different formats. Additionally, exemplary systems, architectures, and pipelines are detailed below. Examples of the instruction(s) may be executed on such systems, architectures, and pipelines, but are not limited to those detailed.

**FIG. 10** illustrates examples of an instruction format. As illustrated, an instruction may include multiple components including, but not limited to, one or more fields for: one or more prefixes 1001, an opcode 1003, addressing information 1005 (e.g., register identifiers, memory addressing information, etc.), a displacement value 1007, and/or an immediate 1009. Note that some instructions utilize some or all of the fields of the format whereas others may only use the field for the opcode 1003. In some examples, the order illustrated is the order in which these fields are to be encoded, however, it should be appreciated that in other examples these fields may be encoded in a different order, combined, etc.

The prefix(es) field(s) 1001, when used, modifies an instruction. In some examples, one or more prefixes are used to repeat string instructions (e.g., 0xF0, 0xF2, 0xF3, etc.), to provide section overrides (e.g., 0x2E, 0x36, 0x3E, 0x26, 0x64, 0x65, 0x2E, 0x3E, etc.), to perform bus lock operations, and/or to change operand (e.g., 0x66) and address sizes (e.g., 0x67). Certain instructions require a mandatory prefix (e.g., 0x66, 0xF2, 0xF3, etc.). Certain of these prefixes may be considered "legacy" prefixes. Other prefixes, one or more examples of which are detailed herein, indicate, and/or provide further capability, such as specifying particular registers, etc. The other prefixes typically follow the "legacy" prefixes.

The opcode field 1003 is used to at least partially define the operation to be performed upon a decoding of the instruction. In some examples, a primary opcode encoded in the opcode field 1003 is 1, 2, or 3 bytes in length. In other examples, a primary opcode can be a different length. An additional 3-bit opcode field is sometimes encoded in another field.

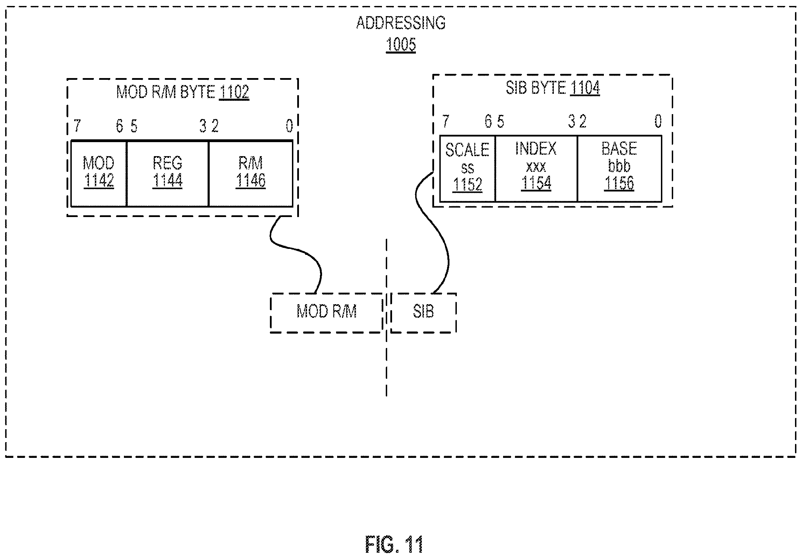

The addressing field 1005 is used to address one or more operands of the instruction, such as a location in memory or one or more registers. **FIG. 11** illustrates examples of the addressing field 1005. In this illustration, an optional ModR/M byte 1102 and an optional Scale, Index, Base (SIB) byte 1104 are shown. The ModR/M byte 1102 and the SIB byte 1104 are used to encode up to two operands of an instruction, each of which is a direct register or effective memory address. Note that each of these fields are optional in that not all instructions include one or more of these fields. The MOD R/M byte 1102 includes a MOD field 1142, a register field 1144, and R/M field 1146.

The content of the MOD field 1142 distinguishes between memory access and non-memory access modes. In some examples, when the MOD field 1142 has a value of b11, a register-direct addressing mode is utilized, and otherwise register-indirect addressing is used.

The register field 1144 may encode either the destination register operand or a source register operand, or may encode an opcode extension and not be used to encode any instruction operand. The content of register index field 1144, directly or through address generation, specifies the locations of a source or destination operand (either in a register or in memory). In some examples, the register field 1144 is supplemented with an additional bit from a prefix (e.g., prefix 1001) to allow for greater addressing.

The R/M field 1146 may be used to encode an instruction operand that references a memory address, or may be used to encode either the destination register operand or a source register operand. Note the R/M field 1146 may be combined with the MOD field 1142 to dictate an addressing mode in some examples.

The SIB byte 1104 includes a scale field 1152, an index field 1154, and a base field 1156 to be used in the generation of an address. The scale field 1152 indicates scaling factor. The index field 1154 specifies an index register to use. In some examples, the index field 1154 is supplemented with an additional bit from a prefix (e.g., prefix 1001) to allow for greater addressing. The base field 1156 specifies a base register to use. In some examples, the base field 1156 is supplemented with an additional bit from a prefix (e.g., prefix 1001) to allow for greater addressing. In practice, the content of the scale field 1152 allows for the scaling of the content of the index field 1154 for memory address generation (e.g., for address generation that uses 2^{scale ∗} index + base).

Some addressing forms utilize a displacement value to generate a memory address. For example, a memory address may be generated according to 2^{scale ∗} index + base + displacement, index^{∗}scale+displacement, r/m + displacement, instruction pointer (RIP/EIP) + displacement, register + displacement, etc. The displacement may be a 1-byte, 2-byte, 4-byte, etc. value. In some examples, a displacement field 1007 provides this value. Additionally, in some examples, a displacement factor usage is encoded in the MOD field of the addressing field 1005 that indicates a compressed displacement scheme for which a displacement value is calculated by multiplying disp8 in conjunction with a scaling factor N that is determined based on the vector length, the value of a b bit, and the input element size of the instruction. The displacement value is stored in the displacement field 1007.

In some examples, an immediate field 1009 specifies an immediate for the instruction. An immediate may be encoded as a 1-byte value, a 2-byte value, a 4-byte value, etc.

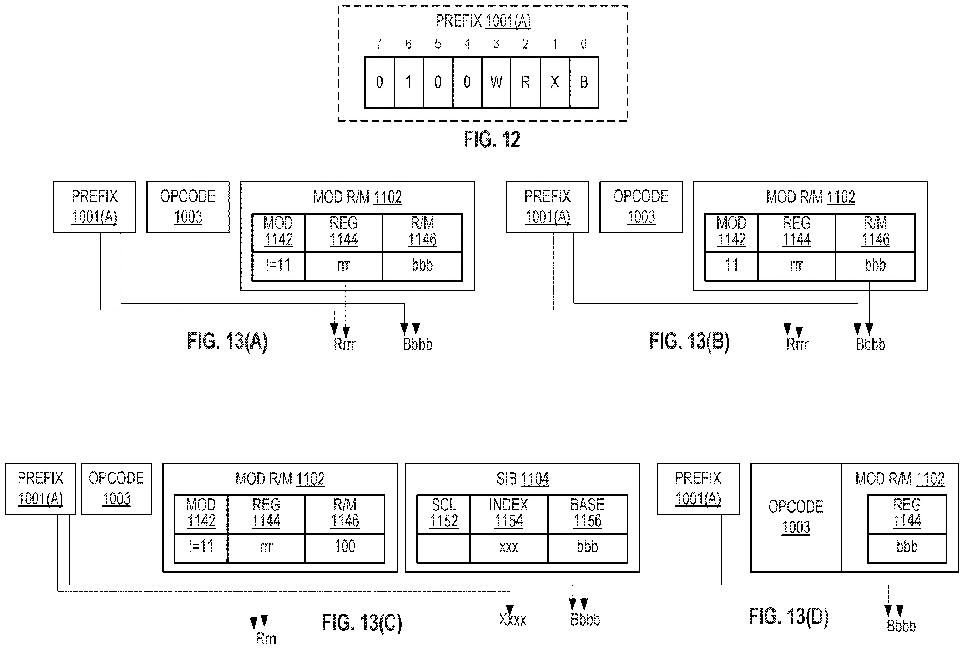

**FIG. 12** illustrates examples of a first prefix 1001(A). In some examples, the first prefix 1001(A) is an example of a REX prefix. Instructions that use this prefix may specify general purpose registers, 64-bit packed data registers (e.g., single instruction, multiple data (SIMD) registers or vector registers), and/or control registers and debug registers (e.g., CR8-CR15 and DR8-DR15).

Instructions using the first prefix 1001(A) may specify up to three registers using 3-bit fields depending on the format: 1) using the reg field 1144 and the R/M field 1146 of the Mod R/M byte 1102; 2) using the Mod R/M byte 1102 with the SIB byte 1104 including using the reg field 1144 and the base field 1156 and index field 1154; or 3) using the register field of an opcode.

In the first prefix 1001(A), bit positions 7:4 are set as 0100. Bit position 3 (W) can be used to determine the operand size, but may not solely determine operand width. As such, when W = 0, the operand size is determined by a code segment descriptor (CS.D) and when W = 1, the operand size is 64-bit.

Note that the addition of another bit allows for 16 (2⁴) registers to be addressed, whereas the MOD R/M reg field 1144 and MOD R/M R/M field 1146 alone can each only address 8 registers.

In the first prefix 1001(A), bit position 2 (R) may an extension of the MOD R/M reg field 1144 and may be used to modify the ModR/M reg field 1144 when that field encodes a general purpose register, a 64-bit packed data register (e.g., a SSE register), or a control or debug register. R is ignored when Mod R/M byte 1102 specifies other registers or defines an extended opcode.

Bit position 1 (X) X bit may modify the SIB byte index field 1154.

Bit position B (B) B may modify the base in the Mod R/M R/M field 1146 or the SIB byte base field 1156; or it may modify the opcode register field used for accessing general purpose registers (e.g., general purpose registers 925).

**FIGS. 13(A)****-(D)** illustrate examples of how the R, X, and B fields of the first prefix 1001(A) are used. **FIG. 13(A)** illustrates R and B from the first prefix 1001(A) being used to extend the reg field 1144 and R/M field 1146 of the MOD R/M byte 1102 when the SIB byte 11 04 is not used for memory addressing. **FIG. 13(B)** illustrates R and B from the first prefix 1001(A) being used to extend the reg field 1144 and R/M field 1146 of the MOD R/M byte 1102 when the SIB byte 11 04 is not used (register-register addressing). **FIG. 13(C)** illustrates R, X, and B from the first prefix 1001(A) being used to extend the reg field 1144 of the MOD R/M byte 1102 and the index field 1154 and base field 1156 when the SIB byte 1104 being used for memory addressing. **FIG. 13(D)** illustrates B from the first prefix 1001(A) being used to extend the reg field 1144 of the MOD R/M byte 1102 when a register is encoded in the opcode 1003.

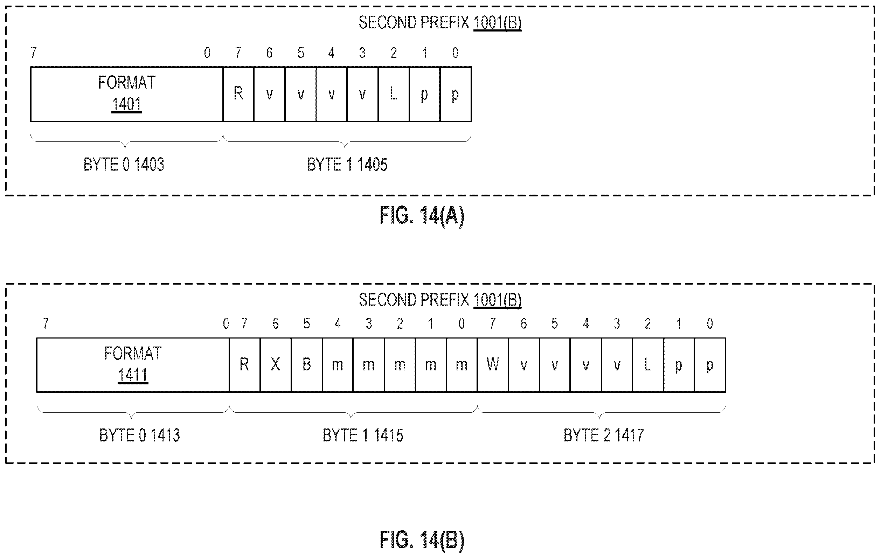

**FIGS. 14(A)****-(B)** illustrate examples of a second prefix 1001(B). In some examples, the second prefix 1001(B) is an example of a VEX prefix. The second prefix 1001(B) encoding allows instructions to have more than two operands, and allows SIMD vector registers (e.g., vector/SIMD registers 910) to be longer than 64-bits (e.g., 128-bit and 256-bit). The use of the second prefix 1001(B) provides for three-operand (or more) syntax. For example, previous two-operand instructions performed operations such as A = A + B, which overwrites a source operand. The use of the second prefix 1001(B) enables operands to perform nondestructive operations such as A = B + C.

In some examples, the second prefix 1001(B) comes in two forms - a two-byte form and a three-byte form. The two-byte second prefix 1001(B) is used mainly for 128-bit, scalar, and some 256-bit instructions; while the three-byte second prefix 1001(B) provides a compact replacement of the first prefix 1001(A) and 3-byte opcode instructions.

**FIG. 14(A)** illustrates examples of a two-byte form of the second prefix 1001(B). In one example, a format field 1401 (byte 0 1403) contains the value C5H. In one example, byte 11405 includes a "R" value in bit[7]. This value is the complement of the same value of the first prefix 1001(A). Bit[2] is used to dictate the length (L) of the vector (where a value of 0 is a scalar or 128-bit vector and a value of 1 is a 256-bit vector). Bits[1:0] provide opcode extensionality equivalent to some legacy prefixes (e.g., 00 = no prefix, 01 = 66H, 10 = F3H, and 11 = F2H). Bits[6:3] shown as vvvv may be used to: 1) encode the first source register operand, specified in inverted (1s complement) form and valid for instructions with 2 or more source operands; 2) encode the destination register operand, specified in 1s complement form for certain vector shifts; or 3) not encode any operand, the field is reserved and should contain a certain value, such as 1111b.

Instructions that use this prefix may use the Mod R/M R/M field 1146 to encode the instruction operand that references a memory address or encode either the destination register operand or a source register operand.

Instructions that use this prefix may use the Mod R/M reg field 1144 to encode either the destination register operand or a source register operand, be treated as an opcode extension and not used to encode any instruction operand.

For instruction syntax that support four operands, vvvv, the Mod R/M R/M field 1146 and the Mod R/M reg field 1144 encode three of the four operands. Bits[7:4] of the immediate 1009 are then used to encode the third source register operand.

**FIG. 14(B)** illustrates examples of a three-byte form of the second prefix 1001(B). in one example, a format field 1411 (byte 0 1413) contains the value C4H. Byte 11415 includes in bits[7:5] "R," "X," and "B" which are the complements of the same values of the first prefix 1001(A). Bits[4:0] of byte 11415 (shown as mmmmm) include content to encode, as need, one or more implied leading opcode bytes. For example, 00001 implies a 0FH leading opcode, 00010 implies a 0F38H leading opcode, 00011 implies a leading 0F3AH opcode, etc.

Bit[7] of byte 2 1417 is used similar to W of the first prefix 1001(A) including helping to determine promotable operand sizes. Bit[2] is used to dictate the length (L) of the vector (where a value of 0 is a scalar or 128-bit vector and a value of 1 is a 256-bit vector). Bits[1:0] provide opcode extensionality equivalent to some legacy prefixes (e.g., 00 = no prefix, 01 = 66H, 10 = F3H, and 11 = F2H). Bits[6:3], shown as vvvv, may be used to: 1) encode the first source register operand, specified in inverted (1s complement) form and valid for instructions with 2 or more source operands; 2) encode the destination register operand, specified in 1s complement form for certain vector shifts; or 3) not encode any operand, the field is reserved and should contain a certain value, such as 1111b.

Instructions that use this prefix may use the Mod R/M R/M field 1146 to encode the instruction operand that references a memory address or encode either the destination register operand or a source register operand.

Instructions that use this prefix may use the Mod R/M reg field 1144 to encode either the destination register operand or a source register operand, be treated as an opcode extension and not used to encode any instruction operand.

For instruction syntax that support four operands, vvvv, the Mod R/M R/M field 1146, and the Mod R/M reg field 1144 encode three of the four operands. Bits[7:4] of the immediate 1009 are then used to encode the third source register operand.

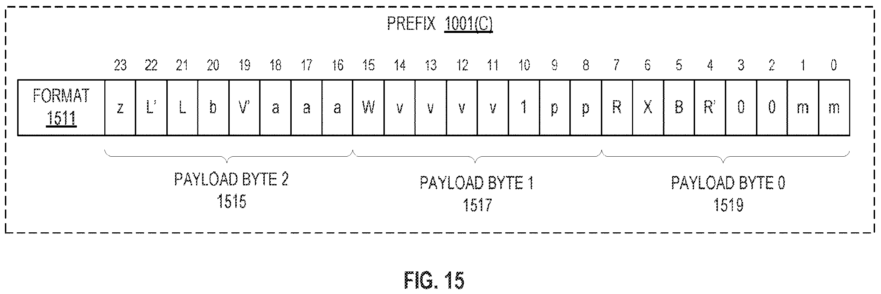

**FIG. 15** illustrates examples of a third prefix 1001(C). In some examples, the first prefix 1001(A) is an example of an EVEX prefix. The third prefix 1001(C) is a four-byte prefix.

The third prefix 1001(C) can encode 32 vector registers (e.g., 128-bit, 256-bit, and 512-bit registers) in 64-bit mode. In some examples, instructions that utilize a writemask/opmask (see discussion of registers in a previous figure, such as **FIG. 9**) or predication utilize this prefix. Opmask register allow for conditional processing or selection control. Opmask instructions, whose source/destination operands are opmask registers and treat the content of an opmask register as a single value, are encoded using the second prefix 1001(B).

The third prefix 1001(C) may encode functionality that is specific to instruction classes (e.g., a packed instruction with "load+op" semantic can support embedded broadcast functionality, a floating-point instruction with rounding semantic can support static rounding functionality, a floating-point instruction with non-rounding arithmetic semantic can support "suppress all exceptions" functionality, etc.).

The first byte of the third prefix 1001(C) is a format field 1511 that has a value, in one example, of 62H. Subsequent bytes are referred to as payload bytes 1515-1519 and collectively form a 24-bit value of P[23:0] providing specific capability in the form of one or more fields (detailed herein).

In some examples, P[1:0] of payload byte 1519 are identical to the low two mmmmm bits. P[3:2] are reserved in some examples. Bit P[4] (R') allows access to the high 16 vector register set when combined with P[7] and the ModR/M reg field 1144. P[6] can also provide access to a high 16 vector register when SIB-type addressing is not needed. P[7:5] consist of an R, X, and B which are operand specifier modifier bits for vector register, general purpose register, memory addressing and allow access to the next set of 8 registers beyond the low 8 registers when combined with the ModR/M register field 1144 and ModR/M R/M field 1146. P[9:8] provide opcode extensionality equivalent to some legacy prefixes (e.g., 00 = no prefix, 01 = 66H, 10 = F3H, and 11 = F2H). P[10] in some examples is a fixed value of 1. P[14:11], shown as vvvv, may be used to: 1) encode the first source register operand, specified in inverted (1s complement) form and valid for instructions with 2 or more source operands; 2) encode the destination register operand, specified in 1s complement form for certain vector shifts; or 3) not encode any operand, the field is reserved and should contain a certain value, such as 1111b.

P[15] is similar to W of the first prefix 1001(A) and second prefix 1011(B) and may serve as an opcode extension bit or operand size promotion.

P[18:16] specify the index of a register in the opmask (writemask) registers (e.g., writemask/predicate registers 915). In one example, the specific value aaa = 000 has a special behavior implying no opmask is used for the particular instruction (this may be implemented in a variety of ways including the use of a opmask hardwired to all ones or hardware that bypasses the masking hardware). When merging, vector masks allow any set of elements in the destination to be protected from updates during the execution of any operation (specified by the base operation and the augmentation operation); in other one example, preserving the old value of each element of the destination where the corresponding mask bit has a 0. In contrast, when zeroing vector masks allow any set of elements in the destination to be zeroed during the execution of any operation (specified by the base operation and the augmentation operation); in one example, an element of the destination is set to 0 when the corresponding mask bit has a 0 value. A subset of this functionality is the ability to control the vector length of the operation being performed (that is, the span of elements being modified, from the first to the last one); however, it is not necessary that the elements that are modified be consecutive. Thus, the opmask field allows for partial vector operations, including loads, stores, arithmetic, logical, etc. While examples are described in which the opmask field's content selects one of a number of opmask registers that contains the opmask to be used (and thus the opmask field's content indirectly identifies that masking to be performed), alternative examples instead or additional allow the mask write field's content to directly specify the masking to be performed.

P[19] can be combined with P[14:11] to encode a second source vector register in a non-destructive source syntax which can access an upper 16 vector registers using P[19]. P[20] encodes multiple functionalities, which differs across different classes of instructions and can affect the meaning of the vector length/ rounding control specifier field (P[22:21]). P[23] indicates support for merging-writemasking (e.g., when set to 0) or support for zeroing and merging-writemasking (e.g., when set to 1).

Examples of encoding of registers in instructions using the third prefix 1001(C) are detailed in the following tables.

**Table 1: 32-Register Support in 64-bit Mode**

| | **4** | **3** | **[2:0]** | **REG. TYPE** | **COMMON USAGES** |
|---|---|---|---|---|---|
| **REG** | R' | R | ModR/M reg | GPR, Vector | Destination or Source |
| **VVVV** | V' | vvvv | | GPR, Vector | 2nd Source or Destination |
| **RM** | X | B | ModR/M R/M | GPR, Vector | 1st Source or Destination |
| **BASE** | 0 | B | ModR/M R/M | GPR | Memory addressing |
| **INDEX** | 0 | X | SIB.index | GPR | Memory addressing |
| **VIDX** | V' | X | SIB.index | Vector | VSIB memory addressing |

**Table 2: Encoding Register Specifiers in 32-bit Mode**

| | **[2:0]** | **REG. TYPE** | **COMMON USAGES** |
|---|---|---|---|
| **REG** | ModR/M reg | GPR, Vector | Destination or Source |
| **VVVV** | vvvv | GPR, Vector | 2^{nd} Source or Destination |
| **RM** | ModR/M R/M | GPR, Vector | 1^{st} Source or Destination |
| **BASE** | ModR/M R/M | GPR | Memory addressing |
| **INDEX** | SIB.index | GPR | Memory addressing |
| **VIDX** | SIB.index | Vector | VSIB memory addressing |

**Table 3: Opmask Register Specifier Encoding**

| | **[2:0]** | **REG. TYPE** | **COMMON USAGES** |
|---|---|---|---|
| **REG** | ModR/M Reg | k0-k7 | Source |
| **VVVV** | vvvv | k0-k7 | 2^{nd} Source |
| **RM** | ModR/M R/M | k0-7 | 1^{st} Source |
| **{k1]** | aaa | k0¹-k7 | Opmask |

Program code may be applied to input instructions to perform the functions described herein and generate output information. The output information may be applied to one or more output devices, in known fashion. For purposes of this application, a processing system includes any system that has a processor, such as, for example, a digital signal processor (DSP), a microcontroller, an application specific integrated circuit (ASIC), or a microprocessor.

The program code may be implemented in a high-level procedural or object-oriented programming language to communicate with a processing system. The program code may also be implemented in assembly or machine language, if desired. In fact, the mechanisms described herein are not limited in scope to any particular programming language. In any case, the language may be a compiled or interpreted language.

Examples of the mechanisms disclosed herein may be implemented in hardware, software, firmware, or a combination of such implementation approaches. Examples may be implemented as computer programs or program code executing on programmable systems comprising at least one processor, a storage system (including volatile and non-volatile memory and/or storage elements), at least one input device, and at least one output device.

One or more aspects of at least one example may be implemented by representative instructions stored on a machine-readable medium which represents various logic within the processor, which when read by a machine causes the machine to fabricate logic to perform the techniques described herein. Such representations, known as "IP cores" may be stored on a tangible, machine readable medium and supplied to various customers or manufacturing facilities to load into the fabrication machines that actually make the logic or processor.

Such machine-readable storage media may include, without limitation, non-transitory, tangible arrangements of articles manufactured or formed by a machine or device, including storage media such as hard disks, any other type of disk including floppy disks, optical disks, compact disk read-only memories (CD-ROMs), compact disk rewritable's (CD-RWs), and magneto-optical disks, semiconductor devices such as read-only memories (ROMs), random access memories (RAMs) such as dynamic random access memories (DRAMs), static random access memories (SRAMs), erasable programmable read-only memories (EPROMs), flash memories, electrically erasable programmable read-only memories (EEPROMs), phase change memory (PCM), magnetic or optical cards, or any other type of media suitable for storing electronic instructions.

Accordingly, examples also include non-transitory, tangible machine-readable media containing instructions or containing design data, such as Hardware Description Language (HDL), which defines structures, circuits, apparatuses, processors and/or system features described herein. Such examples may also be referred to as program products.

### Emulation (including binary translation, code morphing, etc.)

In some cases, an instruction converter may be used to convert an instruction from a source instruction set to a target instruction set. For example, the instruction converter may translate (e.g., using static binary translation, dynamic binary translation including dynamic compilation), morph, emulate, or otherwise convert an instruction to one or more other instructions to be processed by the core. The instruction converter may be implemented in software, hardware, firmware, or a combination thereof. The instruction converter may be on processor, off processor, or part on and part off processor.

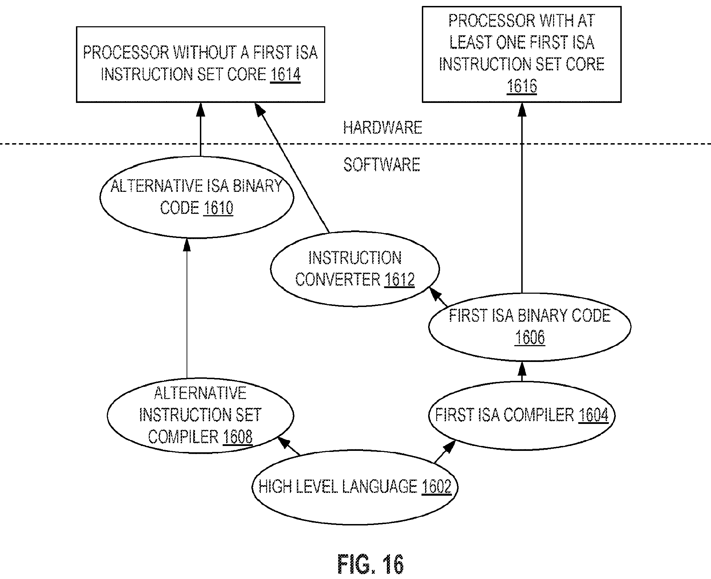

**FIG. 16** illustrates a block diagram contrasting the use of a software instruction converter to convert binary instructions in a source instruction set to binary instructions in a target instruction set according to examples. In the illustrated example, the instruction converter is a software instruction converter, although alternatively the instruction converter may be implemented in software, firmware, hardware, or various combinations thereof. **FIG. 16** shows a program in a high level language 1602 may be compiled using a first ISA compiler 1604 to generate first ISA binary code 1606 that may be natively executed by a processor with at least one first instruction set core 1616. The processor with at least one first ISA instruction set core 1616 represents any processor that can perform substantially the same functions as an Intel^{®} processor with at least one first ISA instruction set core by compatibly executing or otherwise processing (1) a substantial portion of the instruction set of the first ISA instruction set core or (2) object code versions of applications or other software targeted to run on an Intel processor with at least one first ISA instruction set core, in order to achieve substantially the same result as a processor with at least one first ISA instruction set core. The first ISA compiler 1604 represents a compiler that is operable to generate first ISA binary code 1606 (e.g., object code) that can, with or without additional linkage processing, be executed on the processor with at least one first ISA instruction set core 1616. Similarly, **FIG. 16** shows the program in the high level language 1602 may be compiled using an alternative instruction set compiler 1608 to generate alternative instruction set binary code 1610 that may be natively executed by a processor without a first ISA instruction set core 1614. The instruction converter 1612 is used to convert the first ISA binary code 1606 into code that may be natively executed by the processor without a first ISA instruction set core 1614. This converted code is not likely to be the same as the alternative instruction set binary code 1610 because an instruction converter capable of this is difficult to make; however, the converted code will accomplish the general operation and be made up of instructions from the alternative instruction set. Thus, the instruction converter 1612 represents software, firmware, hardware, or a combination thereof that, through emulation, simulation or any other process, allows a processor or other electronic device that does not have a first ISA instruction set processor or core to execute the first ISA binary code 1606.

References to "one example," "an example," etc., indicate that the example described may include a particular feature, structure, or characteristic, but every example may not necessarily include the particular feature, structure, or characteristic. Moreover, such phrases are not necessarily referring to the same example. Further, when a particular feature, structure, or characteristic is described in connection with an example, it is submitted that it is within the knowledge of one skilled in the art to affect such feature, structure, or characteristic in connection with other examples whether or not explicitly described.

Some examples include, but are not limited to:
1. An apparatus comprising:
   random number generator circuitry to generate a random number;
   a memory controller, in response to a command, to initialize at least a proper subset of memory to be one of all zeros or at least one random number to be generated by the random number generator circuitry.
2. The apparatus of example 1, wherein the command is to indicate whether the proper subset of memory is to be initialized to be one of all zeros or at least one random number.
3. The apparatus of example 1, wherein the command is to be generated in response to an execution of an instruction.
4. The apparatus of example 4, wherein the instruction is to have a field for an opcode to indicate execution circuitry is to generate the command to provide to the memory controller.
5. The apparatus of example 5, wherein the opcode is further to indicate whether the proper subset of memory is to be initialized to be one of all zeros or at least one random number.
6. The apparatus of example 5, wherein the instruction further comprises an indication of an operand that is to store an indication of whether the proper subset of memory is to be initialized to be one of all zeros or at least one random number.
7. The apparatus of example 5, wherein the instruction further comprises an immediate that is to encode an indication of whether the proper subset of memory is to be initialized to be one of all zeros or at least one random number.
8. A system comprising:
   memory to store data;
   random number generator circuitry to generate a random number;
   a memory controller, in response to a command, to initialize at least a proper subset of the memory to be one of all zeros or at least one random number to be generated by the random number generator circuitry.
9. The system of example 8, wherein the command is to indicate whether the proper subset of memory is to be initialized to be one of all zeros or at least one random number.
10. The system of example 8, wherein the command is to be generated in response to an execution of an instruction.
11. The system of example 10, wherein the instruction is to have a field for an opcode to indicate execution circuitry is to generate the command to provide to the memory controller.
12. The system of example 11, wherein the opcode is further to indicate whether the proper subset of memory is to be initialized to be one of all zeros or at least one random number.
13. The system of example 11, wherein the instruction further comprises an indication of an operand that is to store an indication of whether the proper subset of memory is to be initialized to be one of all zeros or at least one random number.
14. The system of example 11, wherein the instruction further comprises an immediate that is to encode an indication of whether the proper subset of memory is to be initialized to be one of all zeros or at least one random number.
15. A method comprising:
   generating a command to indicate to a memory controller to initialize at least a proper subset of memory to be one of all zeros or at least one random number;
   in the memory controller, in response to a command, initializing at least a proper subset of memory to be one of all zeros or at least one random number.
16. The method of example 15, wherein the command is to indicate whether the proper subset of memory is to be initialized to be one of all zeros or at least one random number.
17. The method of example 15, wherein the command is to be generated in response to an execution of an instruction.
18. The method of example 17, wherein the instruction is to have a field for an opcode to indicate execution circuitry is to generate the command to provide to the memory controller.
19. The method of example 18, wherein the opcode is further to indicate whether the proper subset of memory is to be initialized to be one of all zeros or at least one random number.
20. The method of example 18, wherein the instruction further comprises an indication of an operand that is to store an indication of whether the proper subset of memory is to be initialized to be one of all zeros or at least one random number.

Moreover, in the various examples described above, unless specifically noted otherwise, disjunctive language such as the phrase "at least one of A, B, or C" is intended to be understood to mean either A, B, or C, or any combination thereof (e.g., A, B, and/or C). As such, disjunctive language is not intended to, nor should it be understood to, imply that a given example requires at least one of A, at least one of B, or at least one of C to each be present.

The specification and drawings are, accordingly, to be regarded in an illustrative rather than a restrictive sense. It will, however, be evident that various modifications and changes may be made thereunto without departing from the broader spirit and scope of the disclosure as set forth in the claims.

## Claims

1. An apparatus comprising:
random number generator circuitry to generate a random number;
a memory controller, in response to a command, to initialize at least a proper subset of memory to be one of all zeros or at least one random number to be generated by the random number generator circuitry.

2. The apparatus of claim 1, wherein the command is to indicate whether the proper subset of memory is to be initialized to be one of all zeros or at least one random number.

3. The apparatus of any of claims 1-2, wherein the command is to be generated in response to an execution of an instruction.

4. The apparatus of claim 4, wherein the instruction is to have a field for an opcode to indicate execution circuitry is to generate the command to provide to the memory controller.

5. The apparatus of claim 5, wherein the opcode is further to indicate whether the proper subset of memory is to be initialized to be one of all zeros or at least one random number.

6. The apparatus of claim 5, wherein the instruction further comprises an indication of an operand that is to store an indication of whether the proper subset of memory is to be initialized to be one of all zeros or at least one random number.

7. The apparatus of claim 5, wherein the instruction further comprises an immediate that is to encode an indication of whether the proper subset of memory is to be initialized to be one of all zeros or at least one random number.

8. A method comprising:
generating a command to indicate to a memory controller to initialize at least a proper subset of memory to be one of all zeros or at least one random number;
in the memory controller, in response to a command, initializing at least a proper subset of memory to be one of all zeros or at least one random number.

9. The method of claim 8, wherein the command is to indicate whether the proper subset of memory is to be initialized to be one of all zeros or at least one random number.

10. The method of any of claims 8-9, wherein the command is to be generated in response to an execution of an instruction.

11. The method of claim 10, wherein the instruction is to have a field for an opcode to indicate execution circuitry is to generate the command to provide to the memory controller.

12. The method of claim 10, wherein the opcode is further to indicate whether the proper subset of memory is to be initialized to be one of all zeros or at least one random number.

13. The method of claim 10, wherein the instruction further comprises an indication of an operand that is to store an indication of whether the proper subset of memory is to be initialized to be one of all zeros or at least one random number.

14. A computer program comprising instructions which, when the program is executed by a computer, cause the computer to carry out the method as claimed in any preceding claim.
